# EUROPÄISCHE PATENTANMELDUNG

(11) **EP 4 660 637 A1**
(43) Veröffentlichungstag der Anmeldung: **10.12.2025**
(21) Anmeldenummer: 25180088.4
(22) Anmeldetag: 02.06.2025
(51) Int. Cl.: G01R 15/18, G01R 15/20

(54) **POSITIONIERUNGSHILFE FÜR EINEN KERNLOSEN STROMSENSOR**

(30) Priorität: 05.06.2024 DE 102024115678
(71) Anmelder: Bourns, Inc., Riverside, CA 92507 (US)
(72) Erfinder: Wessels, Gerhard, 85560 Ebersberg (DE); Tarakhovsky, Maxim D., Lake Orion, MI 48362 (US)
(74) Vertreter: von Bülow & Tamada

(57) **Zusammenfassung**

Die Erfindung betrifft eine Vorrichtung (2, 2', 2") zum Positionieren eines kernlosen Sensors (4) relativ zu einem einen elektrischen Strom in einer Stromflussrichtung (6) führenden elektrischen Leiter (12), umfassend:
- ein einen Innenraum (14) zum Aufnehmen des kernlosen Sensors (4) eingrenzendes Gehäuse (16);
- eine das Gehäuse (16) in der Stromflussrichtung (6) durchdringende Durchgangsöffnung (18), in der der elektrische Leiter (12) quer zur Stromflussrichtung (6) formschlüssig einsetzbar ist, und
- eine in einem vorbestimmten Abstand quer zur Stromflussrichtung (6) im Innenraum (14) angeordnete Einrichtung (20) zum Halten des kernlosen Sensors (4) in einer vorbestimmten Position relativ zur Durchgangsöffnung (18).

## Beschreibung

Die vorliegende Erfindung betrifft eine Positionierungshilfe für einen kernlosen Stromsensor gemäß dem Oberbegriff des geltenden Anspruchs 1.

Die relative Position zwischen kernlosen Sensoren und dem elektrischen Leiter, dessen Strom sie erfassen sollen, hat Einfluss auf ihre Funktion. Herkömmlich werden kernlose Sensoren daher kalibriert, wie beispielhaft in der DE 10 2022 212 545 A1.

Aufgabe der Erfindung ist es, die Kalibrierung kernlosen Sensoren zumindest zu vereinfachen oder sogar zu vermeiden.

Die Aufgabe wird durch die Merkmale der unabhängigen Ansprüche gelöst. Bevorzugte Weiterbildungen sind Gegenstand der abhängigen Ansprüche.

Gemäß einem Aspekt der Erfindung, umfasst Vorrichtung zum Positionieren eines kernlosen Sensors relativ zu einem einen elektrischen Strom in einer Stromflussrichtung führenden elektrischen Leiter, umfassend:
- ein einen Innenraum zum Aufnehmen des kernlosen Sensors eingrenzendes Gehäuse;
- eine das Gehäuse in der Stromflussrichtung durchdringende Durchgangsöffnung, in der der elektrische Leiter quer zur Stromflussrichtung formschlüssig einsetzbar ist, und
- eine in einem vorbestimmten Abstand quer zur Stromflussrichtung im Innenraum angeordnete Einrichtung zum Halten des kernlosen Sensors in einer vorbestimmten Position relativ zur Durchgangsöffnung.

Die angegebene Vorrichtung zur Positionierung eines kernlosen Sensors ermöglicht eine präzise und exakte Ausrichtung des Sensors relativ zum elektrischen Leiter. Das Gehäuse mit der Durchgangsöffnung, durch die der elektrische Leiter quer zur Stromflussrichtung eingeführt wird, sorgt für eine formschlüssige und somit stabile Platzierung des Leiters. Durch diese Konstruktion wird sichergestellt, dass der Leiter stets in einer definierten Position zur Durchgangsöffnung und somit zum Sensor liegt.

Der Sensor selbst wird innerhalb des Gehäuses in einem vorbestimmten Abstand quer zur Stromflussrichtung mittels einer Halteeinrichtung fixiert. Diese Anordnung gewährleistet, dass der Sensor immer in der Position relativ zum elektrischen Leiter positioniert ist, in der das durch den elektrischen Strom erregte Magnetfeld optimal für die Strommessung ist. Durch die exakte und reproduzierbare Positionierung des Sensors in Relation zum Leiter, in der die physikalischen Bedingungen für Messungen immer gleichbleiben, wird die Notwendigkeit der eingangs genannten Kalibrierung stark reduziert, wenn nicht gar eliminiert.

Die präzise Positionierung ermöglicht konsistente Messergebnisse und minimiert potenzielle Fehlerquellen, die bei freier Positionierung des elektrischen Leiters zum Sensor auftreten können. Daher kann die eingangs genannte Kalibrierung des Sensors, die normalerweise notwendig wäre, um Abweichungen aufgrund von Positionierungsfehlern zu korrigieren, vereinfacht oder komplett umgangen werden. Diese Effizienzsteigerung führt nicht nur zu zuverlässigeren Messwerten, sondern auch zu einer vereinfachten Handhabung und Wartung der gesamten Messvorrichtung.

In einer Weiterbildung umfasst die angegebene Vorrichtung Rasthaken, die eingerichtet sind, den elektrischen Leiter in einer Richtung quer zur Stromflussrichtung zu halten.

Die Integration von Rasthaken die angegebene Vorrichtung bietet weitere Vorteile, indem sie den elektrischen Leiter sicher und stabil in der Richtung quer zur Stromflussrichtung hält. Diese Rasthaken greifen den Leiter formschlüssig und verhindern, dass er sich während der Messung verschiebt oder vibriert. Dadurch wird eine konstante Positionierung des Leiters relativ zum Sensor sichergestellt, was die Genauigkeit der Messungen weiter erhöht.

Ein wesentlicher Vorteil dieser Konstruktion ist die weitere Reduzierung des Risikos einer Verschiebung des elektrischen Leiters relativ zum Sensor und somit die weitere Reduktion der Notwendigkeit einer Kalibrierung. Da die Rasthaken den Leiter präzise fixieren, bleibt die räumliche Beziehung zwischen Sensor und Leiter konstant, selbst wenn die Vorrichtung häufig verwendet oder in unterschiedlichen Umgebungen eingesetzt wird. Diese Konstanz in der Positionierung eliminiert viele der variablen Faktoren, die normalerweise eine Kalibrierung des Sensors erforderlich machen würden.

Darüber hinaus erleichtern die Rasthaken die Installation und das Setup der Vorrichtung. Techniker können den Leiter schnell und einfach in die Vorrichtung einsetzen, wobei die Rasthaken sofort einen sicheren Halt bieten. Dies beschleunigt den gesamten Vorbereitungsprozess für Messungen und minimiert die Zeit, die für die Einstellung und Wartung der Vorrichtung benötigt wird.

Zusammengefasst verbessern die Rasthaken nicht nur die Messgenauigkeit durch stabilere Positionierung des Leiters, sondern vereinfachen auch die Handhabung der Vorrichtung und reduzieren den Bedarf an wiederkehrender Kalibrierung. Dies führt zu effizienteren Arbeitsabläufen und zuverlässigeren Ergebnissen bei der Nutzung des Sensors in praktischen Anwendungen.

In einer zusätzlichen Weiterbildung umfasst die angegebene Vorrichtung Stützbeine zur Auflage des elektrischen Leiters, so dass der elektrische Leiter in der Richtung quer zur Stromflussrichtung gesehen zwischen den Rasthaken und den Stützbeinen positionierbar ist.

Die Ergänzung von Stützbeinen zur Auflage des elektrischen Leiters in der angegebenen Vorrichtung erweitert die Funktionalität und Stabilität des Systems und trägt zusätzlich zur Reduzierung der Notwendigkeit einer Kalibrierung bei. Diese Stützbeine sorgen dafür, dass der Leiter fest und sicher zwischen ihnen und den Rasthaken positioniert wird. Dies erhöht die mechanische Stabilität des Leiters, indem es potenzielle Bewegungen und Vibrationen während der Messung verhindert.

Die festgelegte Position des Leiters durch die Stützbeine trägt dazu bei, dass der Abstand und die Ausrichtung zum Sensor über eine längere Zeit konstant gehalten werden können. Eine solche Konfiguration minimiert die Einflussfaktoren, die zu Messabweichungen führen könnten, wie etwa eine versehentliche Verschiebung des Leiters oder eine Änderung in der physikalischen Umgebung. Dies trägt direkt zu einer höheren Genauigkeit und Zuverlässigkeit der Messdaten bei.

Ein weiterer Vorteil der Stützbeine ist die Vereinfachung des Setup-Prozesses. Techniker können den Leiter schnell und ohne großen Aufwand in die Vorrichtung einsetzen, wobei die Kombination aus Rasthaken und Stützbeinen eine sofortige und effektive Fixierung ermöglicht. Dies spart Zeit und reduziert die Komplexität bei der Vorbereitung von Messungen.

Durch die robuste Konstruktion, die durch die Hinzunahme von Stützbeinen erreicht wird, wird die Lebensdauer der Vorrichtung insgesamt verbessert. Da weniger physische Belastungen auf den einzelnen Komponenten lasten, sind weniger Wartungs- und Reparaturarbeiten erforderlich.

In einer anderen Weiterbildung der angegebenen Vorrichtung besitzt das Gehäuse ein erstes Gehäuseteil und ein zweites Gehäuseteil, mit dem das erste Gehäuseteil verschließbar ist.

Die Gestaltung der Vorrichtung mit einem ersten und einem zweiten Gehäuseteil, die miteinander verschließbar sind, bringt mehrere Vorteile, die insbesondere die Handhabung, Sicherheit und die Kalibrierungsanforderungen betreffen.

Erstens ermöglicht das zweiteilige Gehäuse einen einfachen Zugang zum Innenraum der Vorrichtung. Dies ist besonders nützlich beim Einsetzen des Sensors und des elektrischen Leiters sowie bei Wartungsarbeiten. Techniker können das Gehäuse öffnen, die Komponenten problemlos positionieren oder austauschen und das Gehäuse dann wieder sicher verschließen. Diese Zugänglichkeit vereinfacht den Setup-Prozess erheblich und reduziert die Zeit, die für die Vorbereitung und Durchführung der Messungen benötigt wird.

Zweitens sorgt das verschließbare Design für eine hohe Stabilität und Sicherheit der internen Komponenten. Wenn das Gehäuse geschlossen ist, sind der Sensor und der elektrische Leiter fest und geschützt positioniert, was die Wahrscheinlichkeit von Bewegungen oder Vibrationen, die die Messgenauigkeit beeinträchtigen könnten, minimiert. Diese Konstanz ist entscheidend, um die Notwendigkeit häufiger Kalibrierungen zu reduzieren, da die Messbedingungen stabil bleiben.

Drittens bietet das verschließbare Gehäuse einen zusätzlichen Schutz gegen äußere Einflüsse wie Staub, Feuchtigkeit und mechanische Beschädigungen. Dies erhält die Integrität der Sensoren und anderer empfindlicher Komponenten und gewährleistet, dass ihre Leistung und Zuverlässigkeit über längere Zeiträume erhalten bleibt. Dies trägt dazu bei, dass die Kalibrierung seltener notwendig wird, weil die Umgebungsbedingungen weniger Einfluss auf die Messgenauigkeit haben.

Insgesamt führt das Design mit einem ersten und zweiten verschließbaren Gehäuseteil dazu, dass die Vorrichtung einfacher zu handhaben, sicherer in der Nutzung und robuster gegenüber Umwelteinflüssen ist. Dies resultiert in einer Verringerung der Notwendigkeit für Kalibrierungen, was sowohl die Betriebskosten senkt als auch die Effizienz und Zuverlässigkeit der Messprozesse verbessert.

In einer besonderen Weiterbildung der angegebenen Vorrichtung ist die Durchgangsöffnung als quer zur Stromflussrichtung einseitig geöffnete Aussparung in wenigstens eines der Gehäuseteile eingeformt, die beim Aufsetzen des entsprechend anderen Gehäuseteils verschließbar ist.

Die Konzeption der Durchgangsöffnung als einseitig geöffnete Aussparung in mindestens einem der Gehäuseteile, die durch das Aufsetzen des anderen Gehäuseteils verschließbar ist, bietet eine innovative Lösung, die sowohl die Funktionalität als auch die Präzision der Vorrichtung erheblich verbessert.

Ein wesentlicher Vorteil dieser Gestaltung ist die Vereinfachung der Installation des elektrischen Leiters. Da die Aussparung einseitig geöffnet ist, kann der Leiter einfach und schnell von einer Seite eingelegt werden, ohne dass er durch das Gehäuse gefädelt werden muss. Dies reduziert die Zeit und den Aufwand, die für das Einsetzen und Entfernen des Leiters benötigt werden, und erleichtert den gesamten Montageprozess.

Sobald das zweite Gehäuseteil aufgesetzt wird, wird die Aussparung geschlossen, wodurch der Leiter sicher und fest in Position gehalten wird. Diese Art der Fixierung sorgt für eine sehr genaue Positionierung des Leiters relativ zum Sensor, was für die Messgenauigkeit entscheidend ist. Indem die Position des Leiters exakt definiert und stabilisiert wird, werden Messabweichungen, die durch Vibrationen oder Verschiebungen des Leiters entstehen könnten, minimiert.

Diese präzise und sichere Verankerung des Leiters in der Durchgangsöffnung trägt direkt zur Reduktion der Notwendigkeit einer Kalibrierung bei. Da der Leiter fest in seiner Position gehalten wird, bleiben die Bedingungen für die Messungen konstant, was die Genauigkeit erhöht und die Häufigkeit erforderlicher Kalibrierungen reduziert. Dies ist besonders wichtig in Anwendungen, bei denen hohe Präzision und Zuverlässigkeit der Messergebnisse gefordert sind.

Darüber hinaus bietet die Gestaltung mit der einseitig geöffneten und durch das andere Gehäuseteil verschließbaren Aussparung einen zusätzlichen Schutz für den Leiter. Es schützt ihn vor äußeren Einflüssen wie Staub und Feuchtigkeit, was die Lebensdauer der Komponenten verlängert und die Wartungskosten senkt.

In einer besonderen Weiterbildung der angegebenen Vorrichtung sind Querfixierungselemente an der Aussparung ausgebildet.

Die Querfixierungselemente können die oben genannten Rasthaken sein, die direkt an der Aussparung in einem der Gehäuseteile sind und die Funktionalität der Vorrichtung weiter optimieren. Durch die Positionierung der Rasthaken an der Aussparung, wo der elektrische Leiter eingesetzt wird, ergibt sich eine Reihe von Vorteilen, die sich positiv auf die Präzision und Handhabung der Vorrichtung auswirken.

Zunächst einmal gewährleistet diese Anordnung eine sehr direkte und robuste Fixierung des Leiters genau an der Stelle, wo die Messung erfolgt. Die Rasthaken, die an der Aussparung ausgebildet sind, klemmen den Leiter sicher und verhindern, dass er sich während der Messung verschiebt. Diese feste und unverrückbare Positionierung ist entscheidend für die Genauigkeit der Messergebnisse, da jede Bewegung des Leiters potenziell die Messdaten verfälschen könnte.

Diese stabile Fixierung durch die Rasthaken reduziert die Notwendigkeit regelmäßiger Kalibrierungen. Da der Leiter stets in der exakt gleichen Position gehalten wird, bleiben die Bedingungen für die Messungen konstant. Dies führt zu einer höheren Verlässlichkeit der Messwerte und verringert die Wahrscheinlichkeit, dass Abweichungen durch Positionsänderungen des Leiters korrigiert werden müssen.

Ein weiterer Vorteil dieser Konfiguration ist die Vereinfachung des Installationsprozesses. Die Rasthaken, die direkt an der Aussparung positioniert sind, ermöglichen ein schnelles und einfaches Einsetzen des Leiters in die Vorrichtung. Techniker können den Leiter einfach in die Aussparung legen, und die Rasthaken sorgen automatisch für eine sichere Verriegelung. Dies beschleunigt den gesamten Setup-Prozess und minimiert die Zeit, die für die Vorbereitung der Messungen benötigt wird.

Abschließend bietet die Integration der Rasthaken an der Aussparung auch einen zusätzlichen mechanischen Schutz für den Leiter. Indem der Leiter fest an seinem Platz gehalten wird, wird er vor äußeren Einflüssen geschützt, die sonst zu Schäden oder Abnutzung führen könnten. Dies trägt zur Langlebigkeit der Vorrichtung und zur Konsistenz der Messungen über längere Zeiträume hinweg bei.

In einer noch anderen Weiterbildung umfasst die angegebene Vorrichtung Rastelemente, die eingerichtet sind, die beiden Gehäuseteile in einem zum Gehäuse zusammengesetzen Zustand miteinander zu verrasten.

Die Einbeziehung von Rastelementen, die dazu eingerichtet sind, die beiden Gehäuseteile in einem zusammengesetzten Zustand miteinander zu verrasten, bringt wesentliche Vorteile für die Stabilität und Funktionalität der Vorrichtung, was wiederum die Messgenauigkeit verbessert und den Bedarf an Kalibrierungen reduzieren kann.

Erstens sorgen diese Rastelemente für eine feste und dauerhafte Verbindung der beiden Gehäuseteile. Wenn die Gehäuseteile sicher miteinander verrastet sind, wird die gesamte Struktur der Vorrichtung stabiler. Dies ist besonders wichtig, da jegliches Spiel oder Bewegungen zwischen den Gehäuseteilen zu Variationen in der Position des Sensors relativ zum Leiter führen könnten, was die Messgenauigkeit beeinträchtigt. Eine solide und unveränderliche Struktur gewährleistet, dass der Sensor und der elektrische Leiter in einer konstanten, vorherbestimmten Relation zueinander bleiben, was eine gleichbleibend hohe Messqualität sicherstellt.

Zweitens erleichtern die Rastelemente die Montage und Demontage der Vorrichtung. Sie ermöglichen es den Benutzern, die Gehäuseteile schnell und ohne zusätzliches Werkzeug zusammenzusetzen oder zu trennen. Dies vereinfacht den Prozess des Einsetzens oder Austauschens von Komponenten erheblich und spart Zeit bei der Vorbereitung der Messungen. Die einfache Handhabung durch die Rastelemente macht die Vorrichtung benutzerfreundlicher und minimiert menschliche Fehler beim Zusammenbau.

Drittens tragen die Rastelemente dazu bei, die Vorrichtung gegen äußere Einflüsse wie Vibrationen, Stöße oder Umwelteinflüsse zu schützen, die sonst die Komponenten beeinträchtigen könnten. Diese Schutzfunktion ist essentiell, um die Langlebigkeit und Zuverlässigkeit der Messvorrichtung zu gewährleisten und die Notwendigkeit für regelmäßige Wartung und Kalibrierung zu reduzieren.

Schließlich ermöglichen die Rastelemente, dass einmal etablierte Kalibrierungseinstellungen erhalten bleiben, selbst wenn die Vorrichtung häufig transportiert oder neu zusammengesetzt wird. Dies stabilisiert die Messbedingungen über längere Zeiträume und verschiedene Einsatzorte hinweg und macht wiederholte Kalibrierungen oft unnötig.

In einer weiteren Weiterbildung umfasst die angegebene Vorrichtung eine quer zur Stromflussrichtung verlaufende Führungsnut an einem der Gehäuseteile, in die eine entsprechend am anderen Gehäuseteil ausgebildete Führungsnase zum quer zur Stromflussrichtung geführten Zusammensetzen der beiden Gehäuseteile zum Gehäuse einsetzbar ist.

Die Konzeption einer Führungsnut in einem der Gehäuseteile und einer entsprechenden Führungsnase am anderen Gehäuseteil stellt eine intelligente Lösung zur präzisen und reproduzierbaren Ausrichtung der Gehäuseteile zueinander dar. Dieses Design bietet mehrere Vorteile, die speziell die Montagegenauigkeit, Stabilität und die Wartungsfreundlichkeit der Vorrichtung verbessern, und trägt direkt zur Minimierung des Kalibrierungsbedarfs bei.

Erstens sorgt die Führungsnut-Führungsnase-Konstruktion für eine exakte und einfache Zusammenführung der Gehäuseteile. Diese präzise Führung erleichtert das Zusammensetzen der Komponenten, indem sie sicherstellt, dass die Gehäuseteile jedes Mal korrekt ausgerichtet werden, ohne dass es Raum für menschliche Fehler gibt. Eine solche genaue Positionierung ist entscheidend, da sie die Konsistenz der Platzierung von Sensor und Leiter innerhalb des Gehäuses garantiert, was direkt die Messgenauigkeit beeinflusst.

Zweitens reduziert die genaue Führung der Gehäuseteile durch Nut und Nase mechanische Spannungen und Abnutzung, die bei häufigem Zusammen- und Auseinanderbauen entstehen könnten. Dies erhöht die Lebensdauer der Vorrichtung und minimiert die Notwendigkeit von Reparaturen oder Austauschen von Komponenten. Dies trägt wiederum zur Senkung der Wartungskosten und zur Steigerung der Zuverlässigkeit des Gesamtsystems bei.

Drittens bewirkt die stabile und präzise Verbindung der Gehäuseteile eine Verringerung von Vibrationen und Bewegungen während des Betriebs. Diese Stabilität ist besonders wichtig in Umgebungen, wo externe Einflüsse wie Erschütterungen oder Stöße die Messergebnisse verfälschen könnten. Durch die Führungsnut und -nase wird der Sensor in einer fest definierten Position zum Leiter gehalten, was die Notwendigkeit von Kalibrierungen nach jedem Aufbau der Vorrichtung deutlich reduziert.

Schließlich bietet die Führungsnut und -nase auch bei regelmäßigem Transport der Vorrichtung eine zusätzliche Sicherheit, dass die Ausrichtung der Komponenten konstant bleibt. Dies ist insbesondere von Vorteil in Szenarien, in denen die Vorrichtung an verschiedenen Orten eingesetzt wird und dabei immer wieder montiert und demontiert werden muss.

In einer weiteren Weiterebildung der angegebenen Vorrichtung ist eine Kante der Durchgangsöffnung in einer Richtung quer zur Stromflussrichtung spitz zulaufend ausgebildet.

Die Überlegung, eine Kante der Durchgangsöffnung spitz zulaufend zu gestalten, reduziert Lagetoleranz und erhöht die Stabilität der Positionierung des elektrischen Leiters innerhalb der Vorrichtung, insbesondere wenn das Gehäusematerial eine gewisse Elastizität aufweist, wie es bei Kunststoff der Fall ist. Diese Gestaltung und Materialwahl bieten mehrere Vorteile.

Erstens erhöht die spitz zulaufende Kante der Durchgangsöffnung die Kontaktfläche zwischen dem Gehäuse und dem elektrischen Leiter. Wenn das Gehäusematerial, wie Kunststoff, elastisch ist, kann es sich leicht an die Form des Leiters anpassen und um den Leiter herum leicht zusammendrücken. Diese Anpassungsfähigkeit führt dazu, dass der Leiter fester und sicherer in der Durchgangsöffnung sitzt. Durch den engen Kontakt wird der Leiter effektiv vor Vibrationen und Bewegungen geschützt, was die Messgenauigkeit verbessert, indem es die Position des Leiters stabil hält.

Zweitens reduziert die stabile Fixierung des Leiters in der spitz zulaufenden Durchgangsöffnung die Notwendigkeit regelmäßiger Kalibrierungen. Da der Leiter weniger Spielraum für Bewegungen hat, bleiben die Messbedingungen konstant, was die Zuverlässigkeit der Daten erhöht. Diese Konsistenz ist entscheidend für Anwendungen, die eine hohe Präzision erfordern, und minimiert den Aufwand für wiederholte Kalibrierungen, die sonst notwendig wären, um Abweichungen aufgrund von Leiterbewegungen zu korrigieren.

Drittens bietet der Einsatz von Kunststoff als Gehäusematerial zusätzliche Vorteile. Kunststoff ist nicht nur elastisch, sondern auch widerstandsfähig gegen Korrosion und leichter als viele Metalle, was die Handhabung und Installation der Vorrichtung vereinfacht. Darüber hinaus isoliert Kunststoff elektrisch, was die Sicherheit bei der Handhabung von elektrischen Komponenten verbessert.

Schließlich erleichtert die Verwendung einer spitz zulaufenden Kante zusammen mit einem elastischen Gehäusematerial die Montage und Wartung der Vorrichtung. Der Leiter kann leicht in die Durchgangsöffnung eingesetzt und ebenso leicht entfernt werden, ohne dass das Risiko besteht, dass das Gehäusematerial bricht oder sich dauerhaft verformt. Dies macht die Vorrichtung insgesamt benutzerfreundlicher und langlebiger.

In einer noch anderen Weiterbildung umfasst die angegebene Vorrichtung eine weitere Durchgangsöffnung durch das Gehäuse, durch die eine Anschlussschnittstelle für den kernlosen Sensor führbar ist.

Die Hinzufügung einer weiteren Durchgangsöffnung im Gehäuse zur Führung einer Anschlussschnittstelle für den kernlosen Sensor bringt entscheidende Vorteile für die Stabilität und die Zuverlässigkeit der gesamten Messvorrichtung, was wiederum zur Reduktion der Kalibrierungsnotwendigkeit beiträgt. Die Anschlussschnittstelle, verstanden als ein elektrischer Punkt, an dem die Messsignale des Sensors abgreifbar sind, spielt eine zentrale Rolle für die Integration und den Schutz der elektronischen Verbindungen.

Erstens ermöglicht eine dedizierte Durchgangsöffnung für die Anschlussschnittstelle eine geordnete und sichere Führung der elektrischen Verbindungen des Sensors. Dies ist besonders wichtig, um mechanische Spannungen auf die Kabel und Steckverbindungen zu vermeiden, die sonst durch Biegen oder Ziehen während des Betriebs oder bei der Montage entstehen könnten. Eine geordnete Kabelführung trägt nicht nur zur Langlebigkeit der elektronischen Komponenten bei, sondern stellt auch sicher, dass die Signalintegrität nicht durch physikalische Einflüsse beeinträchtigt wird.

Zweitens sorgt die separate Durchgangsöffnung dafür, dass die sensorischen und elektrischen Komponenten physisch voneinander getrennt sind. Diese Trennung ist entscheidend, um Interferenzen oder elektromagnetische Störungen zwischen dem stromführenden Leiter und den empfindlichen Messsignalen des Sensors zu minimieren. Eine stabile und störungsfreie Signalübertragung ist essentiell für die Genauigkeit der Messdaten und kann die Häufigkeit der notwendigen Kalibrierungen reduzieren, da die Messbedingungen zuverlässiger und konsistenter werden.

Drittens verbessert die klare Strukturierung und sichere Unterbringung aller Komponenten die Gesamtstabilität der Vorrichtung. Die festgelegte Platzierung der Anschlussschnittstelle in einer eigenen Durchgangsöffnung unterstützt eine systematische Aufbauweise, die vor mechanischen Fehlern während des Betriebs schützt. Diese robuste Konfiguration fördert eine gleichbleibende Leistung des Sensors, indem sie eine konstante Umgebung ohne störende Einflüsse sichert.

Abschließend fördert die Einrichtung einer speziellen Durchgangsöffnung für die Anschlussschnittstelle eine vereinfachte Wartung und leichtere Zugänglichkeit der elektrischen Verbindungen für Inspektionen oder Reparaturen. Dies vereinfacht den Wartungsprozess und reduziert die Wahrscheinlichkeit von Fehlern oder Schäden, die sonst durch unsachgemäße Handhabung entstehen könnten.

Die oben beschriebenen Eigenschaften, Merkmale und Vorteile dieser Erfindung sowie die Art und Weise wie diese erreicht werden, werden verständlicher im Zusammenhang mit der folgenden Beschreibung der Ausführungsbeispiele, die im Zusammenhang mit der Zeichnung näher erläutert werden. Es zeigen:
Fig. 1a eine perspektivische Darstellung einer ersten Vorrichtung zum Positionieren eines kernlosen Sensors,
Fig. 1b die Vorrichtung aus Fig. 1a in einer Explosionsansicht,
Fig. 1c die Vorrichtung aus Fig. 1a in einem ersten Fertigungszustand,
Fig. 1d die Vorrichtung aus Fig. 1a in einem zweiten Fertigungszustand,
Fig. 2a eine perspektivische Darstellung einer zweiten Vorrichtung zum Positionieren eines kernlosen Sensors,
Fig. 2b die Vorrichtung aus Fig. 2a in einem ersten Fertigungszustand,
Fig. 2c die Vorrichtung aus Fig. 2a in einem zweiten Fertigungszustand,
Fig. 2d die Vorrichtung aus Fig. 2a in einer Schnittansicht,
Fig. 3a eine perspektivische Darstellung einer dritten Vorrichtung zum Positionieren mehrerer kernloser Sensoren,
Fig. 3b die Vorrichtung aus Fig. 3a in einer Explosionsansicht,

In den Figuren werden gleiche technische Elemente mit gleichen Bezugszeichen versehen und nur einmal beschrieben. Die Figuren sind rein schematisch und geben vor allem nicht die tatsächlichen geometrischen Verhältnisse wieder.

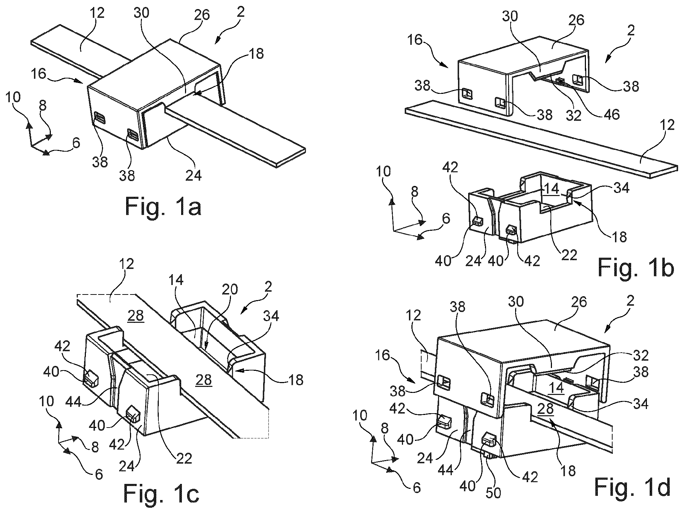

Es wird auf die Figs. 1a, 1b, 1c und 1d Bezug genommen, die entsprechend eine perspektivische Darstellung einer ersten Vorrichtung 2 zum Positionieren eines kernlosen Sensors, die Vorrichtung 2 aus Fig. 1a in einer Explosionsansicht, die Vorrichtung 2 aus Fig. 1a in einem ersten Fertigungszustand und die Vorrichtung 2 aus Fig. 1a in einem zweiten Fertigungszustand zeigen.

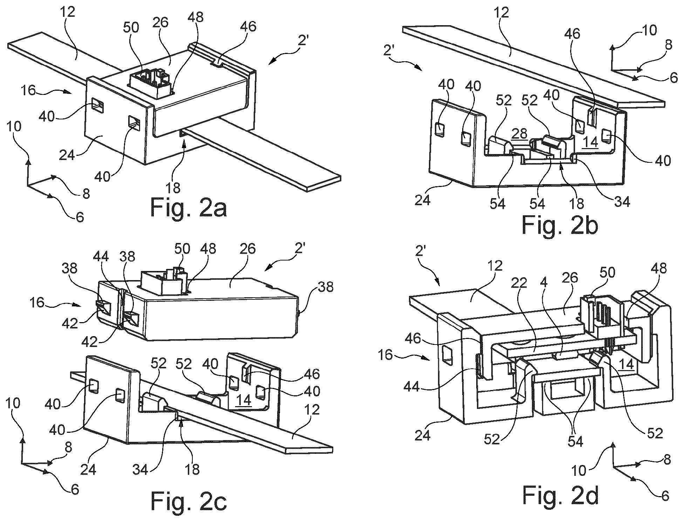

Der kernlose Sensors 4 ist in der Perspektive der Fig. 1a bis 1d nicht zu sehen, aber in Fig. 2d eingezeichnet. Der kernlose Sensor 4, auch als Kernlossensor oder *"coreless sensor"* bezeichnet, ist ein Sensor, der ohne einen ferromagnetischen Kern auskommt. Traditionelle Sensoren verwenden oft einen ferromagnetischen Kern, um das Magnetfeld zu konzentrieren und die Sensitivität zu erhöhen. Der kernlose Sensor 4 verzichtet auf diesen Kern und nutzt stattdessen andere Techniken, um präzise Messungen zu ermöglichen. Dies bringt verschiedene Vorteile mit sich, wie beispielsweise geringere Größe, weniger Gewicht, höhere Präzision und bessere Linearität.

Der kernlose Sensor 4 zeichnet sich durch hohe Präzision und Zuverlässigkeit aus und trägt so zu einer verbesserten Fahrzeugsteuerung und -sicherheit bei.

Der Übersichtlichkeit halber wird die Vorrichtung 2 nachstehend in einem Raum beschrieben, der durch eine Längsrichtung 6, eine Querrichtung 8 quer zur Längsrichtung 6 und eine Höhenrichtung 10 quer zur Längsrichtung 6 und quer zur Querrichtung 8 aufgespannt ist.

Der in den Figs. 1a bis 1d nicht gezeigte kernlose Sensor 4 ist auf einer Leiterplatte 12 angeordnet und dazu vorgesehen einen Strom durch einen elektrischen Leiter, hier in Form einer Sammelschiene, zu messen. Die Sammelschiene 12 ist im Zusammenhang mit dem kernlosen Sensor 4 ein Bauteil, das als elektrischer Verteilungs- und Verbindungsmechanismus dient. Die Sammelschiene 12 ist typischerweise ein flacher, leitender Streifen aus Metall (oft Kupfer oder Aluminium), der mehrere elektrische Schaltkreise oder Komponenten miteinander verbindet, indem er einen gemeinsamen Strompfad bietet.

In der Automobilindustrie findet die Kombination aus Sammelschiene 12 und kernloser Sensor 4 vielfältige Einsatzmöglichkeiten. Ein wesentliches Anwendungsgebiet ist das Batteriemanagementsystem (BMS) in Elektrofahrzeugen. Hier überwacht der kernlose Sensor 4 den Stromfluss durch die Sammelschiene 4, um den Ladezustand und die Gesundheit einer Batterie präzise zu erfassen und zu steuern. Diese Kombination ermöglicht eine effiziente und sichere Energieverteilung innerhalb eines Fahrzeugs. Ein weiteres Einsatzfeld ist die Überwachung von Elektromotoren. Der kernlose Sensor 4 erfasst den Stromfluss durch die Wicklungen des Motors und liefert dadurch wichtige Informationen über die Motorleistung und den Betriebszustand. Dies ist entscheidend für die Optimierung der Motorsteuerung und die Vermeidung von Überlastungen oder Fehlfunktionen. Darüber hinaus kommt die Kombination aus Sammelschiene 12 und kernloser Sensor 4 in Ladeinfrastrukturen für Elektrofahrzeuge zum Einsatz. Sie ermöglicht eine genaue Überwachung und Steuerung des Ladevorgangs, was zu einer höheren Effizienz und Sicherheit beim Laden führt. Dies ist besonders wichtig in Schnellladestationen, wo hohe Ströme gehandhabt werden müssen.

Die Lage des kernlosen Sensors 4 relativ zur Sammelschiene 12 muss präzise bestimmt und fixiert sein. Dies beinhaltet sowohl die horizontale Plazierung in der Höhenrichtung 10 als auch die vertikale Platzierung des kernlosen Sensors 4 in der Querrichtung 8, um optimale Messbedingungen zu gewährleisten.

Dabei muss der kernlose Sensor 4 in der Querrichtung 8 mittig über der Sammelschiene 12 positioniert sein, um das gesamte Magnetfeld, das durch den Stromfluss erzeugt wird, gleichmäßig zu erfassen. Eine mittige Ausrichtung gewährleistet, dass der kernlose Sensor 4 das Magnetfeld entlang der gesamten Breite der Sammelschiene 12 gleichmäßig detektiert.

Des Weiteren ist der in der Höhenrichtung 10 gesehene und nicht weiter referenzierte vertikale Abstand zwischen dem kernlosen Sensor 4 und der Oberfläche der Sammelschiene 12 von großer Bedeutung. Dieser Abstand muss genau festgelegt sein, um sicherzustellen, dass der kernlose Sensor 4 in der optimalen Position für die Magnetfeldmessung ist. Der Strom durch die Sammelschiene 12 erzeugt ein Magnetfeld, dessen Feldstärkenkomponente in Querrichtung für einen gegebenen Abstand proportional zum Strom ist und mit wachsendem Abstand für einen gegebene Stromstärke kleiner wird. Der Abstand des Sensors 4 zur Sammelschiene 12 muss dann so gewählt werden. dass der Messbereich des Magnetfeldsensors den maximalen Stromfluss durch die Sammelschienen erfassen kann. Ein zu großer oder zu kleiner Abstand beeinträchtigen Empfindlichkeit oder Messbereich der Messung.

Die exakte Positionierung umfasst auch die Ausrichtung des kernlosen Sensors 4 parallel zur Sammelschiene 12, um sicherzustellen, dass der kernlose Sensor 4 konsistente und reproduzierbare Messungen liefert. Jegliche Neigung oder Abweichung von der Parallelität führt zu Verzerrungen in den Messwerten. Zusätzlich muss der kernlose Sensor 4 so montiert werden, dass er stabil und sicher befestigt ist, um Vibrationen und Bewegungen standzuhalten, die in einem fahrenden Fahrzeug auftreten können.

Nur wenn die Ausrichtung des kernlosen Sensors 4 zur Sammelschiene 12 präzise ist, werden eine gleichmäßige Erfassung des Magnetfelds gewährleistet, elektromagnetische Interferenzen und Rauschen minimiert, thermische Stabilität sichergestellt und mechanische Stabilität geboten. Diese Faktoren sind entscheidend für die Präzision, Zuverlässigkeit und Langzeitstabilität der Messungen in Anwendungen wie dem Batteriemanagementsystem, der Motorüberwachung und der Ladeinfrastruktur für Elektrofahrzeuge.

Die zuvor genannte präzise Ausrichtung des kernlosen Sensors 4 zur Sammelschiene 12 wird herkömmlich durch einen Kalibrierungsprozess mit mehreren Schritten sichergestellt, die darauf abzielen, die optimale Lage des kernlosen Sensors 4 zur Sammelschiene 12 zu bestimmen und sicherzustellen, dass er präzise und zuverlässige Messungen liefert.

Der Kalibrierungsprozess beginnt gewöhnlich mit der Installation des kernlosen Sensors 4 in der vorgesehenen Position zur Sammelschiene 12, also in der Querrichtung 8 gesehen mittig über der Breite der Sammelschiene und in der Höhenrichtung 10 gesehen in einem optimalen vertikalen Abstand zur Oberfläche. Anschließend werden Testströme durch die Sammelschiene 12 geleitet, wobei der kernlose Sensor 4 die erzeugten Magnetfelder erfasst. Die gemessenen Daten werden analysiert, um sicherzustellen, dass der kernlose Sensor 4 gleichmäßige und korrekte Messwerte liefert. Während dieses Kalibrierungsprozesses werden verschiedene Positionen in der Querrichtung 8 und Abstände in der Höhenrichtung 10 getestet. Der kernlose Sensor 4 wird schrittweise verschoben und die Messungen wiederholt, bis die optimale Position gefunden ist, bei der die Messungen am genauesten und konsistentesten sind. Dies kann durch mechanische Justierungsvorrichtungen, Laserausrichtungen und andere präzise Positionierungstechniken unterstützt werden.

Dieser Kalibrierungsprozess ist allerdings zeitaufwendig und erfordert spezialisierte Ausrüstung und Fachwissen, was die Produktionskosten erhöht. Zudem kann die Kalibrierung in einer Serienfertigung schwierig und aufwendig sein, da der kernlose Sensor 4 individuell angepasst und getestet werden muss. Ein weiterer Nachteil ist die Möglichkeit von Drift und Verschleiß im Laufe der Zeit, was bedeutet, dass der kernlose Sensor 4 regelmäßig neu kalibriert werden muss, um seine Genauigkeit zu gewährleisten. Diese regelmäßigen Wartungsanforderungen können die Betriebskosten erhöhen und die Zuverlässigkeit des Gesamtsystems beeinträchtigen, wenn sie nicht ordnungsgemäß durchgeführt werden.

Hier greift die Vorrichtung 2 mit der Überlegung an, die Ausrichtung des kernlosen Sensors 4 zur Sammelschiene 12 mechanisch zu bestimmen. Hierzu umfasst die Vorrichtung 2 ein einen Innenraum 14 zum Aufnehmen des kernlosen Sensors 4 eingrenzendes Gehäuse 16. Durch dieses Gehäuse 16 ist in einer Stromflussrichtung durch die Sammelschiene 12, die in der vorliegenden Ausführung mit der Längsrichtung 6 identisch ist, eine Durchgangsöffnung 18 geführt, wobei die Sammelschiene 12 quer zur Stromflussrichtung 6 also in der Querrichung 8 und in der Höhenrichtung 10 formschlüssig in die Durchgangsöffnung 18 einsetzbar ist. Die Ausrichtung des kernlosen Sensors 4 zur Sammelschiene 12 wird dabei durch eine Einrichtung 20 zum Halten des kernlosen Sensors 4 bestimmt, die den kernlosen Sensor 4 in einem vorbestimmten Abstand in der Querrichtung 8 und in der Höhenrichtung 10 im Innenraum 14 relativ zur Sammelschiene 12 positioniert.

Die Einrichtung 20 zur Halterung des kernlosen Sensors 4 setzt den Kerngedanken der Vorrichtung 2 um, den kernlosen Sensor 4 sicher und präzise im Innenraum 14 des Gehäuses 16 gegenüber der Sammelschiene 12 zu positionieren. Diese Einrichtung 20 kann beliebige mechanische Verbinungsarten wie stoff-, form- oder kraftschlüssige Verbindungen verwenden, um die Positionierung des kernlosen Sensor 4 in der Querrichtung 8, Längsrichtung 6 und Höhenrichtung 10 im Gehäuse 16 zu gewährleisten. In der vorliegenden Ausführung hält die Einrichtung 20 eine den kernlosen Sensor 4 tragende Leiterplatte 22 im Innenraum des Gehäuses 16 an dessen nicht weiter referenzierten Wänden in der Querrichtung 8 und Längsrichtung 6 formschlüssig und in der Höhenrichtung 10 stoff- oder kraftschlüssig. Der Formschluss gewährleistet eine stabile Positionierung des kernlosen Sensors 4 ohne seitliche Bewegung. In der Höhenrichtung 10 kann die den kernlosen Sensor tragende Leiterplatte 22 durch Federmechanismen, Klemmvorrichtungen oder Klebeverbindungen kraft- oder stoffschlüssig gehalten werden, um eine genaue vertikale Positionierung sicherzustellen und Bewegungen oder Vibrationen standzuhalten.

Auf diese Weise gewährleistet die Einrichtung 20 zur Halterung des kernlosen Sensors 4 eine präzise Positionierung des Sensors zur Sammelschiene 12 bereits bei der Installation, die auch während des Betriebs in einem Fahrzeug beständig erhalten bleibt. Dies bringt mehrere entscheidende Vorteile gegenüber der herkömmlichen Kalibrierung. Erstens wird die Notwendigkeit aufwändiger Kalibrierungsverfahren erheblich reduziert oder sogar eliminiert, da die präzise Positionierung des kernlosen Sensors 4 durch die Einrichtung 20 zur Halterung des kernlosen Sensors 4 bereits sichergestellt ist. Dadurch können Produktionszeiten und -kosten gesenkt werden, da jeder kernlose Sensor 4 nicht individuell kalibriert werden muss.

Zweitens bietet die mechanische Fixierung durch die Einrichtung 20 zur Halterung des kernlosen Sensors 4 eine dauerhaft stabile Positionierung, die unabhängig von externen Einflüssen wie Vibrationen, thermischen Ausdehnungen oder mechanischen Belastungen ist. Dies erhöht die Langzeitstabilität und Zuverlässigkeit der Messungen erheblich, da der kernlose Sensor 4 nicht nachträglich justiert oder neu kalibriert werden muss. Drittens werden durch die exakte mechanische Positionierung potenzielle Messfehler, die durch eine fehlerhafte Kalibrierung entstehen könnten, von vornherein vermieden. Dies führt zu einer höheren Genauigkeit und Konsistenz der Messwerte.

Schließlich trägt die mechanische Fixierung durch die Einrichtung 20 zur Halterung des kernlosen Sensors 4 zur Vereinfachung des Designs und der Wartung bei. Der kernlose Sensor 4 kann einfacher ausgetauscht werden, ohne dass eine erneute aufwändige Kalibrierung notwendig ist, was die Wartungsfreundlichkeit und die Systemzuverlässigkeit weiter erhöht. Insgesamt bietet die präzise Positionierung durch die Einrichtung 20 zur Halterung des kernlosen Sensors 4 somit erhebliche Vorteile in Bezug auf Kosten, Zuverlässigkeit, Genauigkeit und Wartungsfreundlichkeit gegenüber herkömmlichen Kalibrierungsverfahren.

Das Gehäuse 16 kann beliebig ausgeführt, um den kernlosen Sensor 4 optimal aufzunehmen und zu schützen. Es kann einstufig oder mehrstufig sein, je nach den spezifischen Anforderungen der Anwendung. Eine einstufige Ausführung besteht aus einem einzigen Gehäuseteil, das den gesamten Innenraum 14 bildet und den Sensor sowie die Sammelschiene 12 direkt aufnimmt. Diese Konstruktion bietet eine einfache Montage und robuste Stabilität, da weniger Verbindungsstellen vorhanden sind, die potenziell Schwachstellen darstellen könnten. Eine weitere Alternative ist ein modular aufgebautes Gehäuse 16, das aus mehreren miteinander verbundenen Einzelteilen besteht. Dies ermöglicht eine flexible Anpassung an unterschiedliche Einbausituationen und erleichtert die Erweiterung oder Modifikation der Vorrichtung 2.

In der vorliegenden Ausführung besitzt das Gehäuse 16 ein erstes Gehäuseteil 24 und ein zweites Gehäuseteil 26, mit dem das erste Gehäuseteil 24 verschließbar ist. Diese zweiteilige Konstruktion ermöglicht eine leichtere Installation und Wartung des kernlosen Sensors 4. Das erste Gehäuseteil 24 dient dabei als Basis, die den Innenraum 14 und die Durchgangsöffnung 18 für die Sammelschiene 12 bildet. Der kernlose Sensor 4 wird auf der Leiterplatte 22 im Innenraum 14 positioniert, wobei das erste Gehäuseteil 24 die formschlüssige Halterung der Leiterplatte 22 in der Querrichtung 8 und Längsrichtung 6 sicherstellt.

Das zweite Gehäuseteil 26 verschließt das erste Gehäuseteil 24, um den Innenraum 14 vollständig abzudecken. Dies bietetet nicht zusätzlichen Schutz vor äußeren Einflüssen wie Staub, Feuchtigkeit und mechanischen Stößen. Durch den Verschluss mit dem zweiten Gehäuseteil 26 wird zudem sichergestellt, dass der kernlose Sensor 4 auch in der Höhenrichtung 10 formschlüssig und damit stabil gehalten wird.

Hierzu umfasst die Durchgangsöffnung 18 quer zur Stromflussrichtung 6 einseitig geöffnete Aussparungen 28, die in das erste Gehäuseteil 24 eingeformt sind und die beim Aufsetzen des zweiten Gehäuseteils 26 verschlossen werden. Die Aussparungen 28 sind der Übersichtlichkeit halber nicht alle mit einem eigenen Bezugszeichen versehen. Am ersten Gehäuseteil 24 sind Führungsplatten 30 ausgebildet, wobei in jede Aussparung 28 eine Führungsplatte 30 eingeführt wird, die so die Sammelschiene 12 in die Aussparungen 28 drücken. Von den Führungsplatten 30 sind in der Perspektive der Figuren nicht alle zu sehen. Das Drücken wird durch eine in der Höhenrichtung 10 an der Unterseite jeder Führungsplatte 30 ausgebildete Höhenquetschlippe 32, also eine Verjüngung, intensiviert.

Die Höhenquetschlippe 32 sorgt dafür, dass die Sammelschiene 12 in der Höhenrichtung 10 sowohl formschlüssig als auch kraftschlüssig in der Durchgangsöffnung 18 fixiert wird, was Toleranzen ausgleicht, die durch das Zusammensetzen der beiden Gehäuseteile 24, 26 in die Vorrichtung 2 eingebracht werden. Die Verjüngung der Höhenquetschlippe 32 erzeugt einen zusätzlichen Druck auf die Sammelschiene 12, wodurch eine feste mechanische Verbindung sichergestellt wird. Dieser zusätzliche Druck gewährleistet, dass der kernlose Sensor 4 auch bei Vibrationen und mechanischen Belastungen während des Fahrzeugbetriebs in seiner vorgesehenen Position bleibt.

Zusätzlich zu den Höhenquetschlippen 32 können in den Aussparungen 28 Querquetschlippen 34 ausgebildet sein, die sich analog zu den Höhenquetschlippen 32 gestalten lassen, jedoch in der Querrichtung 8 ausgerichtet sind. Von den Querquetschlippen 34 sind in den Figuren nicht alle mit einem eigenen Bezugszeichen versehen. Die Querquetschlippen 34 sorgen dafür, dass die Sammelschiene 12 auch in der Querrichtung 8 sowohl formschlüssig als auch kraftschlüssig fixiert wird. Die Verjüngung der Querquetschlippen 34 erzeugt einen zusätzlichen Druck auf die Sammelschiene 12.

Die Querquetschlippen 34 stabilisieren die Sammelschiene 12 während des Betriebs nicht nur weiter, sie sorgen auch dafür, dass die Sammelschiene 12 während der Montage sicher und fest gehalten wird, was den Einbau erleichtert und die korrekte Positionierung sicherstellt. Einmal fixiert, bieten die Querquetschlippen 34 eine dauerhafte Fixierung, die auch bei Vibrationen und mechanischen Belastungen nicht nachgibt. Die Querquetschlippen 34 gewährleisten so neben der stabilen und sicheren Fixierung der Sammelschiene 12 in der Querrichtung 8 eine erleichterte Montage, da die Sammelschiene 12 automatisch in die richtige Position geführt und fixiert werden, was die Notwendigkeit für zusätzliche Justierungen oder Werkzeuge verringert.

Ein weiterer Vorteil ist eine verbesserte Vibrations- und Stoßfestigkeit, da sie als zusätzliche Fixierungselemente eine mehrdimensionale Stabilisierung sicherstellen. Dies ist besonders wichtig im rauen Betriebsumfeld eines Fahrzeugs, wo ständige Vibrationen und mechanische Belastungen auftreten. Zudem können die Querquetschlippen 34 dazu beitragen, Montagefehler zu reduzieren, da sie die korrekte Ausrichtung der Sammelschiene 12 sicherstellen und die Positionierung des kernlosen Sensors 4 erleichtern.

Das zweite Gehäuseteil 26 ist so ausgebildet, dass es über das erste Gehäuseteil 24 gestülpt werden kann. Hierbei sind am ersten Gehäuseteil 24 Rastnasen 38 ausgebildet, die in speziell vorgesehenen Rastenaussparungen 40 des zweiten Gehäuseteils 26 einrasten können. Von diesen Rastnasen 38 und Rastaussparungen sind in der Perspektive der Figuren nicht alle zu sehen. Das Einrasten erfolgt automatisch beim Aufstülpen des zweiten Gehäuseteils 26 auf das erste Gehäuseteil 24, wodurch eine stabile und sichere Verbindung der beiden Gehäuseteile 24, 26 gewährleistet wird.

Um das Einrasten der Rastnasen 38 zu erleichtern, sind diese mit Rampen 42 versehen. Diese Rampen 42 sind abgeschrägte Flächen an den Rastnasen 38, die beim Aufstülpen des zweiten Gehäuseteils 26 eine gleichmäßige und reibungsarme Führung in die Rastenaussparungen 40 ermöglichen. Durch diese Konstruktion wird der Kraftaufwand beim Zusammenfügen der Gehäuseteile minimiert und die Montage insgesamt vereinfacht.

Das stülpbare Design des zweiten Gehäuseteils 26 über das erste Gehäuseteil 24 bietet mehrere Vorteile. Erstens ermöglicht es eine schnelle und einfache Montage, da die Gehäuseteile ohne zusätzliche Werkzeuge oder komplexe Befestigungsmethoden miteinander verbunden werden können. Zweitens sorgt das Einrasten der Rastnasen 38 in die Rastenaussparungen 40 für eine sichere und dauerhafte Verbindung, die auch bei Vibrationen und mechanischen Belastungen stabil bleibt.

Zusätzlich bietet dieses Design eine erhöhte Flexibilität und Wartungsfreundlichkeit. Falls eine Wartung oder ein Austausch des kernlosen Sensors 4 erforderlich ist, kann das zweite Gehäuseteil 26 einfach abgenommen werden, indem die Rastnasen 38 aus den Rastenaussparungen 40 gelöst werden. Dadurch wird der Zugang zum Innenraum 14 und zu den darin enthaltenen Komponenten erleichtert.

Zusätzlich sind am ersten Gehäuseteil 24 eine in der Höhenrichtung 10 verlaufende Führungsnuten 44 ausgebildet. In jede Führungsnut 44 lassen sich entsprechend am zweiten Gehäuseteil 26 ausgebildete Führungsnaseen 46 einsetzen. Von den Führungsnuten 44 und den Führungsnasen 46 sind in der Perspektive der Figuren nicht alle zu sehen. Ferner sind der Übersichtlichkeit halber auch nicht alle Führungsnuten 44 und Führungsnasen 46 mit einem eigenen Bezugszeichen versehen. Die Führungsnasen 46 sind so gestaltet, dass sie in die entsprechenden Führungsnuten 44 eingreifen und die beiden Gehäuseteile 24, 26 in der Höhenrichtung zusammengeführt werden können.

Unter dem Begriff Führungsnase 46 ist ein Vorsprung zu verstehen, dessen in der Höhenrichtung 10 gesehene Länge nicht eingeschränkt ist. Die Länge jeder Führungsnase 46 kann anwendungsabhängig gewählt werden und hat Einfluss auf die Stabilität und Präzision der Verbindung. Eine längere Führungsnase 46 bietet eine größere Kontaktfläche innerhalb ihrer Führungsnut 44, was die mechanische Führung verbessert und das Risiko von Fehljustierungen während der Montage verringert. Zudem sorgt eine längere Führungsnase 46 für eine höhere Stabilität gegen seitliche Bewegungen und mechanische Belastungen, was die Gesamtintegrität der Verbindung erhöht. Andererseits bringt eine kürzere Führungsnase 46 den Vorteil, das Risiko eines Verkantens zu minimieren und die Reibung während der Montage zu reduzieren. Dies erleichtert das Einführen und Zusammenfügen der Gehäuseteile 24, 26 und ermöglicht eine schnellere und einfachere Montage.

Durch die Führungen aus je einer Führungsnut 44 und einer Führungsnase 46 wird die Montage der Gehäuseteile 24, 26 erheblich erleichtert, da eine klare und präzise Ausrichtung ermöglicht wird. Dies minimiert Montagefehler und sorgt dafür, dass die Gehäuseteile 24, 26 korrekt zusammengefügt werden. Zweitens gewährleistet die mechanische Führung eine stabile und robuste Verbindung, die auch bei Vibrationen und mechanischen Belastungen während des Betriebs eines Fahrzeugs zuverlässig bleibt. Schließlich trägt die präzise Ausrichtung der Gehäuseteile 24, 26 zur Genauigkeit und Zuverlässigkeit des gesamten Gesamtsystems bei, indem sie sicherstellt, dass der kernlose Sensor 4 in der optimalen Position relativ zur Sammelschiene 12 bleibt.

Die Führungsnuten 44 können zumindest bereichsweise trichterförmig zulaufend ausgebildet sein. Diese Gestaltung der Führungsnuten 44 erleichtert das Einführen der entsprechenden Führungsnase 46 und sorgt für eine präzise Zentrierung der Gehäuseteile 24, 26 während des Montageschritts. Durch die trichterförmig zulaufende Form wird jede Führungsnase 46 automatisch in die richtige Position geleitet, was den Montageprozess weiter vereinfacht und die Gefahr von Fehlplatzierungen reduziert. Zudem kann die trichterförmig zulaufende Form jeder Führungsnut 44 die Stabilität der Verbindung erhöhen, indem sie einen formschlüssigen und sicheren Halt der entsprechenden Führungsnase 46 innerhalb der Nut gewährleistet.

Zusätzlich weist das Gehäuse 16 eine weitere Durchgangsöffnung 48 auf, durch die eine Anschlussschnittstelle 50 für den kernlosen Sensor 4 führbar ist. Die Durchgangsöffnung 48 ist in der Perspektive der Fig. 1a bis 1d nicht zu sehen, aber in Fig. 2a eingezeichnet. Sie ermöglicht den Zugang zur Anschlussschnittstelle 50, welche die Verbindung des kernlosen Sensors 4 mit externen Geräten oder Systemen herstellt. Die Durchgangsöffnung 48 ist so positioniert, dass die Anschlussschnittstelle 50 bei der Montage einfach und sicher durch das Gehäuse 16 geführt werden kann. Dabei trägt die Anschlussschnittstelle 50 zur Positionierung des kernlosen Sensors 4 bei, indem sie einen Formschluss quer zur Höhenrichtung 10 schafft. Dies erhöht die Stabilität und Genauigkeit der Sensorpositionierung, ohne die Dichtheit des Gehäuses zu beeinträchtigen. Die beschriebene Konstruktion erleichtert die Installation und den Anschluss des Sensors 4 und gewährleistet eine zuverlässige Datenübertragung und Energieversorgung.

Der Aufbau des kernlosen Sensors 4 erfolgt in mehreren Schritten: Zunächst wird die den kernlosen Sensor 4 tragende Leiterplatte 22 in das erste Gehäuseteil 24 eingesetzt. Dabei wird darauf geachtet, dass die Leiterplatte 22 formschlüssig und stabil in der vorgesehenen Position im Innenraum 14 des ersten Gehäuseteils 24 sitzt. Dabei muss darauf geachtet werden, dass die Anschlussschnittstelle 50 durch die weitere Durchgangsöffnung 48 im ersten Gehäuseteil 24 geführt ist. Dies stellt automatisch sicher, dass die Anschlussschnittstelle 50 korrekt positioniert und zugänglich ist.

Das zweite Gehäuseteil 26 wird nun auf das erste Gehäuseteil 24 aufgesetzt. Dabei werden die Führungsnasen 46 in die Führungsnuten 44 eingeführt. Die beiden Gehäuseteile 24, 26 werden quer zur Stromflussrichtung 6 zusammengeführt. Beide Gehäuseteile 24 und 26 werden aufeinander geschoben, bis die Rampen 42 erreicht werden. Durch leichten Druck entgegen der Höhenrichtung 10 rasten die Rastnasen 38 in die Rastenaussparungen 40 ein und sorgen so für eine stabile und sichere Verbindung der beiden Gehäuseteile.

Für die Demontage wird ein Werkzeug, wie ein Schraubendreher, benötigt, um die Rastnasen 38 zu lösen. Da auf der anderen Seite der Rastnasen keine Rampe vorhanden ist, muss der Schraubendreher zwischen die Gehäuseteile 24, 26 eingeführt werden, um die Rastnasen 38 aus den Rastenaussparungen 40 zu hebeln. Sobald die Rastnasen 38 gelöst sind, kann das zweite Gehäuseteil 26 vom ersten Gehäuseteil 24 abgezogen werden, indem die Führungsnasen 46 aus den Führungsnuten 44 entfernt werden. Schließlich kann die Leiterplatte 22 mit dem kernlosen Sensor 4 aus dem ersten Gehäuseteil 24 entnommen werden.

Es wird auf die Figs. 2a, 2b, 2c und 2d Bezug genommen, die entsprechend eine perspektivische Darstellung einer zweiten Vorrichtung 2' zum Positionieren des kernlosen Sensors 4, die Vorrichtung 2' aus Fig. 2a in einem ersten Fertigungszustand, die Vorrichtung 2' aus Fig. 2a in einer Explosionsansicht, und die Vorrichtung 2' aus Fig. 2a in einer Schnittansicht zeigen.

Der Hauptunterschied bei der zweiten Vorrichtung 2' besteht darin, dass die Funktionen des ersten Gehäuseteils 24 und des zweiten Gehäuseteils 26 vertauscht sind. In dieser Ausführung hält das erste Gehäuseteil 24 nun ausschließlich die Sammelschiene 12. Alle anderen Elemente der Gehäuseteile sind vertauscht angeordnet, um die Funktionalität beizubehalten.

Im Detail bedeutet dies, dass die Durchgangsöffnung 18, die zuvor im ersten Gehäuseteil 24 angeordnet war, nun im zweiten Gehäuseteil 26 zu finden ist. Entsprechend befindet sich die Führungsnut 44, die in der ersten Vorrichtung 2 quer zur Stromflussrichtung 6 im ersten Gehäuseteil 24 verläuft, jetzt am zweiten Gehäuseteil 26. Die dazugehörige Führungsnase 46, die in der ersten Vorrichtung 2 am zweiten Gehäuseteil 26 ausgebildet ist, ist nun am ersten Gehäuseteil 24 vorhanden. Des Weiteren sind die Rastnasen 38 und Rastenaussparungen 40 ebenfalls vertauscht: Die Rastnasen 38 mit den Rampen 38 befinden sich jetzt am zweiten Gehäuseteil 26, während die Rastenaussparungen 40 am ersten Gehäuseteil 24 zu finden sind.

Diese vertauschte Anordnung der Gehäuseteile bedeutet, dass bei der Montage die Führungsnase 46 des ersten Gehäuseteils 24 in die Führungsnut 44 des zweiten Gehäuseteils 26 eingeführt wird. Das zweite Gehäuseteil 26 wird dann auf das erste Gehäuseteil 24 geschoben, bis die Rampen 42 die Rastnasen 38 in die Rastenaussparungen 40 führen. Der Druck entgegen der Höhenrichtung 10 bewirkt das Einrasten und sichert die stabile Verbindung der beiden Gehäuseteile.

Durch diese vertauschte Anordnung bleibt die grundsätzliche Funktionalität der ersten Vorrichtung 2 in der zweiten Vorrichtung 2' erhalten. In der ersten Vorrichtung 2 allerdings positioniert das erste Gehäuseteil 24 sowohl die Sammelschiene 12 als auch den kernlosen Sensor 4. Dies bedeutet, dass die gesamte Verantwortung für die präzise Ausrichtung und Stabilität des kernlosen Sensors 4 allein auf dem ersten Gehäuseteil 24 liegt. In der zweiten Vorrichtung 2' wird demgegenüber die Positionierung der Sammelschiene 12 und des kernlosen Sensors 4 hingegen entkoppelt. Das erste Gehäuseteil 24 übernimmt nun ausschließlich die Haltefunktion für die Sammelschiene 12. Die präzise Positionierung des kernlosen Sensors 4 erfolgt durch das zweite Gehäuseteil 26. Diese Entkopplung der Positionierungsaufgaben bietet mehrere Vorteile:

Erstens wird die Komplexität der einzelnen Gehäuseteile reduziert. Das erste Gehäuseteil 24 kann sich auf die stabile und sichere Halterung der Sammelschiene 12 konzentrieren, ohne gleichzeitig die präzise Ausrichtung des Sensors sicherstellen zu müssen. Dies vereinfacht die Konstruktion und kann die Herstellungskosten senken. Zweitens wird die Montageflexibilität erhöht. Da die Positionierung des kernlosen Sensors 4 und der Sammelschiene 12 nun getrennt erfolgt, können beide Elemente unabhängig voneinander in das Gehäuse eingebracht und justiert werden. Dies erleichtert den Montageprozess und reduziert das Risiko von Fehlern, da die Justierung der Sammelschiene 12 und des Sensors 4 nicht gleichzeitig erfolgen muss. Drittens erhöht diese Entkopplung die Stabilität und Genauigkeit der gesamten Vorrichtung 2'. Da jede Gehäusehälfte nun spezifische Aufgaben übernimmt, können beide Teile so gestaltet werden, dass sie ihre jeweilige Funktion optimal erfüllen. Die Sammelschiene 12 wird im ersten Gehäuseteil 24 stabil fixiert, während das zweite Gehäuseteil 26 den kernlosen Sensor 4 präzise positioniert. Dies führt zu einer insgesamt robusteren und zuverlässigeren Konstruktion.

Zusätzlich bietet die Entkopplung der Positionierungsaufgaben Vorteile bei der Wartung und Reparatur. Wenn ein Austausch oder eine Justierung der Sammelschiene 12 oder des Sensors 4 erforderlich ist, kann dies unabhängig voneinander durchgeführt werden, ohne die gesamte Vorrichtung demontieren zu müssen. Dies spart Zeit und Aufwand und erhöht die Wartungsfreundlichkeit der Vorrichtung.

In der zweiten Vorrichtung 2' ist das erste Gehäuseteil 24 mit zusätzlichen Rasthaken 52 und Stützbeinen 54 ausgestattet, die eine präzise und stabile Positionierung der Sammelschiene 12 in der Höhenrichtung 10 ermöglichen. Die Rasthaken 52 halten die Sammelschiene 12 in der Höhenrichtung 10, während die Stützbeine 54 als Auflagepunkte für die Sammelschiene 12 entgegen der Höhenrichtung 10 dienen. Diese konstruktiven Merkmale tragen entscheidend zur Stabilität und Genauigkeit der zweiten Vorrichtung 2' bei.

Die Rasthaken 52 sind in das erste Gehäuseteil 24 integriert und befinden in der Querrichtung 8 gesehen vor und hinter den Stützbeinen 54, um die Sammelschiene 12 formschlüssig in der Höhenrichtung 10 zu fixieren. Ist die Sammelschiene daher auf die ebenfalls in das erste Gehäuseteil 24 integrierten Stützbeine 54 aufgelegt, umgreifen die Rasthaken 52 die Sammelschiene 12 so dass die Sammelschiene 12 in und entgegen der Höhenrichtung formschlüssig gehalten ist.

Die Rasthaken 52 sorgen auf diese Weise für eine sichere und feste Halterung der Sammelschiene 12. Durch das Einrasten der Sammelschiene 12 in die Rasthaken 52 wird diese zuverlässig in der gewünschten Position gehalten, wodurch eine unerwünschte Bewegung in der Höhenrichtung 10 verhindert wird. Diese formschlüssige Halterung durch die Rasthaken 52 ergänzt die kraftschlüssige Funktion der Querquetschlippen 34 vor allem während der Montage. Zudem bieten die Stützbeine 54 zusätzliche Stabilität, indem sie als Auflagepunkte für die Sammelschiene 12 dienen. Die Sammelschiene 12 wird in der Höhenrichtung 10 zwischen den Rasthaken 52 und den Stützbeinen 54 positioniert, was eine exakte Ausrichtung und eine stabile Lage sicherstellt. Die Stützbeine 54 tragen das Gewicht der Sammelschiene 12 und verhindern ein Durchhängen oder Verrutschen, wodurch die mechanische Belastung gleichmäßig verteilt wird. Durch diese zusätzliche Sicherung der Sammelschiene 12 wird die gesamte Vorrichtung 2' in ihrer strukturellen Integrität und Funktionssicherheit verbessert. Die Kombination aus Rasthaken 52 und Stützbeinen 54 stellt schließlich sicher, dass die Sammelschiene 12 nicht nur präzise positioniert, sondern auch unter Betriebsbedingungen stabil gehalten wird. Dies ist besonders wichtig, um die zuverlässige Funktion des kernlosen Sensors 4 zu gewährleisten, da eine stabile Sammelschiene 12 die Genauigkeit der Messungen und die langfristige Zuverlässigkeit der Vorrichtung erhöht.

Zum Aufbau der zweiten Vorrichtung 2' wird zunächst die den kernlosen Sensor 4 tragende Leiterplatte 22 analog zur ersten Vorrichtung 2 allerdings in das zweite Gehäuseteil 26 eingesetzt. Anders als bei der ersten Vorrichtung 2 wird als nächstes die Sammelschiene 12 in das andere Gehäuseteil 24 eingeführt. Dazu wird die Sammelschiene 12 durch die Rasthaken 52 gedrückt, bis sie fest auf den Stützbeinen 54 aufliegt. Die Rasthaken 52 greifen dabei die Sammelschiene 12 und halten sie sicher in der Höhenrichtung 10. Die restliche Montage erfolgt analog zur ersten Vorrichtung 2.

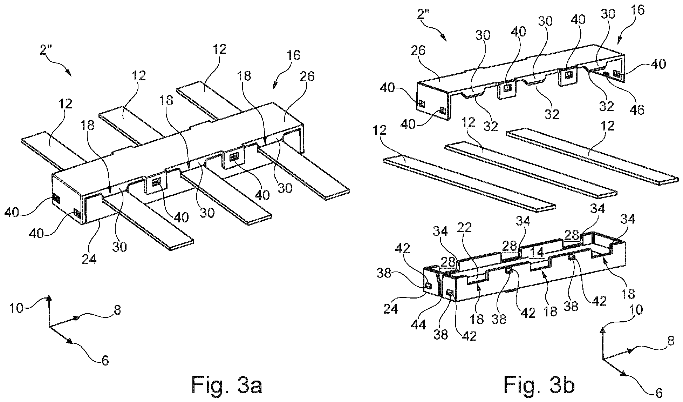

Abschließend wird noch auf die Fig. 3a und 3b Bezug genommen, die entsprechend eine perspektivische Darstellung einer dritten Vorrichtung 2" zum Positionieren mehrerer kernloser Sensoren in einer perspektivischen Ansicht und in einer Explosionsansicht zeigen.

Die dritte Vorrichtung 2" ist grundsätzliche wie die ersten Vorrichtung 2 aufgebaut, allerdings werden hier mehrere Sammelschienen 12 parallel zueinander positioniert. Um einen sicheren Halt zu gewährleisten, sind die Rastelemente 38, 40, 42 auch zwischen den einzelnen Sammelschienen 12 angeordnet.

Die dritte Vorrichtung 2" lässt sich analog auch ausgehend vom Aufbau der zweiten Vorrichtung 2' realisieren.

### Bezugszeichenliste

- 2, 2', 2": Vorrichtung zum Positionieren eines kernlosen Sensors
- 4: kernloser Sensor
- 6: Stromflussrichtung
- 8: Querrichtung (quer zur Stromflussrichtung)
- 10: Hölhenrichtung (vertikal zur Stromflussrichtung und Querrichtung)
- 12: elektrischer Leiter / Sammelschiene
- 14: Innenraum des Gehäuses
- 16: Gehäuse
- 18: Durchgangsöffnung für den elektrischen Leiter
- 20: Einrichtung zum Halten des kernlosen Sensors
- 22: Leiterplatte (mit Sensor)
- 24: Erstes Gehäuseteil
- 26: Zweites Gehäuseteil
- 28: Aussparung (einseitig geöffnete Öffnung im Gehäuse)
- 30: Führungsplatte
- 32: Höhenquetschlippe
- 34: Querquetschlippe / Querfixierungselement
- 38: Rastnase
- 40: Rastenaussparung
- 42: Rampe (an Rastnase)
- 44: Führungsnut
- 46: Führungsnase
- 48: weitere Durchgangsöffnung für Anschlussschnittstelle
- 50: Anschlussschnittstelle für den kernlosen Sensor
- 52: Rasthaken zur Fixierung der Sammelschiene
- 54: Stützbein zur Auflage der Sammelschiene

## Patentansprüche

1. Vorrichtung (2, 2', 2") zum Positionieren eines kernlosen Sensors (4) relativ zu einem einen elektrischen Strom in einer Stromflussrichtung (6) führenden elektrischen Leiter (12), umfassend:
- ein einen Innenraum (14) zum Aufnehmen des kernlosen Sensors (4) eingrenzendes Gehäuse (16);
- eine das Gehäuse (16) in der Stromflussrichtung (6) durchdringende Durchgangsöffnung (18), in der der elektrische Leiter (12) quer zur Stromflussrichtung (6) formschlüssig einsetzbar ist, und
- eine in einem vorbestimmten Abstand quer zur Stromflussrichtung (6) im Innenraum (14) angeordnete Einrichtung (20) zum Halten des kernlosen Sensors (4) in einer vorbestimmten Position relativ zur Durchgangsöffnung (18).

2. Vorrichtung (2, 2', 2") nach Anspruch 1, umfassend Rasthaken (52), die eingerichtet sind, den elektrischen Leiter (12) in einer Richtung (10) quer zur Stromflussrichtung (6) zu halten.

3. Vorrichtung (2, 2', 2") nach Anspruch 2, umfassend Stützbeine (54) zur Auflage des elektrischen Leiters (6), so dass der elektrische Leiter (6) in der Richtung (10) quer zur Stromflussrichtung (6) gesehen zwischen den Rasthaken (52) und den Stützbeinen (54) positionierbar ist.

4. Vorrichtung (2, 2', 2") einem der Ansprüche 1 bis 3, wobei das Gehäuse (18) ein erstes Gehäuseteil (24) und ein zweites Gehäuseteil (26) besitzt, mit dem das erste Gehäuseteil (24) verschließbar ist.

5. Vorrichtung (2, 2', 2") nach Anspruch 4, wobei die Durchgangsöffnung (18) als quer zur Stromflussrichtung (10) einseitig geöffnete Aussparung (28) in wenigstens eines der Gehäuseteile (24, 26) eingeformt ist, die beim Aufsetzen des entsprechend anderen Gehäuseteils (26, 24) verschließbar ist.

6. Vorrichtung (2, 2', 2") nach Anspruch 5, wobei Querfixierungselemente (34) an der Aussparung (28) ausgebildet sind.

7. Vorrichtung (2, 2', 2") nach einem der Ansprüche 4 bis 6, umfassend Rastelemente (38, 40, 42), die eingerichtet sind, die beiden Gehäuseteile (24, 26) in einem zum Gehäuse (16) zusammengesetzen Zustand miteinander zu verrasten.

8. Vorrichtung (2, 2', 2") nach einem der Ansprüche 4 bis 7, umfassend eine quer zur Stromflussrichtung (10) verlaufende Führungsnut (44) an einem der Gehäuseteile (24, 26), in die eine entsprechend am anderen Gehäuseteil (26, 24) ausgebildete Führungsnase (46) zum quer zur Stromflussrichtung (10) geführten Zusammensetzen der beiden Gehäuseteile (24, 26) zum Gehäuse (16) einsetzbar ist.

9. Vorrichtung (2, 2', 2") nach einem der vorstehenden Ansprüche, wobei eine Kante der Durchgangsöffnung (28) in einer Richtung (8) quer zur Stromflussrichtung (6) spitz zulaufend ausgebildet ist.

10. Vorrichtung (2, 2', 2") nach einem der vorstehenden Ansprüche, umfassend eine weitere Durchgangsöffnung (48) durch das Gehäuse (16), durch die eine Anschlussschnittstelle (50) für den kernlosen Sensor (4) führbar ist.

11. Vorrichtung (2, 2', 2") nach einem der vorstehenden Ansprüche, wobei die Halteeinrichtung (20) eine Leiterplatte (22) umfasst, die den kernlosen Sensor (4) trägt, wobei die Leiterplatte (22) im Innenraum (14) des Gehäuses (16) in der Querrichtung (8) und Längsrichtung (6) formschlüssig sowie in der Höhenrichtung (10) kraft- oder stoffschlüssig gehalten ist.

12. Vorrichtung (2, 2', 2") nach Anspruch 11, wobei die Leiterplatte (22) in der Höhenrichtung (10) durch Federmechanismen, Klemmvorrichtungen oder Klebeverbindungen gehalten ist.

13. Vorrichtung (2, 2', 2") nach einem der vorstehenden Ansprüche, wobei die Führungsnut (44) zumindest bereichsweise trichterförmig ausgebildet ist, um die Zentrierung der Führungsnase (46) beim Zusammenfügen der Gehäuseteile (24, 26) zu erleichtern.

14. Vorrichtung (2, 2', 2") nach einem der vorstehenden Ansprüche, wobei die Rastelemente (38, 40, 42) derart angeordnet sind, dass sie eine werkzeuglose Montage und eine nur mit Werkzeug mögliche Demontage der Gehäuseteile (24, 26) ermöglichen.

15. Vorrichtung (2, 2', 2") nach einem der vorstehenden Ansprüche, wobei die Anschlussschnittstelle (50) zur Positionierung des kernlosen Sensors (4) beiträgt, indem sie einen Formschluss quer zur Höhenrichtung (10) schafft.
